# DEMANDE DE BREVET EUROPEEN

(11) **EP 4 672 600 A1**
(43) Date de publication de la demande: **31.12.2025**
(21) Numéro de dépôt: 25182623.6
(22) Date de dépôt: 13.06.2025
(51) Int. Cl.: H03H 9/54

(54) **CIRCUIT DE FILTRAGE PASSE-BANDE**

(30) Priorité: 26.06.2024 FR 2406847
(71) Demandeur: STMicroelectronics International N.V., 1228 Plan-les-Ouates, Geneva (CH)
(72) Inventeur: BONNET, Benoit, 37100 Tours (FR)
(74) Mandataire: Cabinet Beaumont

(57) **Abrégé**

La présente description concerne un circuit de filtrage passe-bande (100) comprenant, en série, un premier filtre passe-haut (HPF110), un filtre passe-bande (BPF100) et un deuxième filtre passe-haut (HPF120), dans lequel le filtre passe-bande (BPF100) comprend :
- des premier et deuxième résonateurs acoustiques (AWR101, AWR102) disposés en série entre des premier et deuxième noeuds (N102, N103);
- deux premières bobines (LBPF101, LBF102) disposées en série entre elles, et disposées en parallèle avec ledit premier résonateur acoustique (AWR101) ;
- deux deuxièmes bobines (LBPF103, LBF104) disposées en série entre elles, et disposées en parallèle avec ledit deuxième résonateur acoustique (AWR102) ;
- un troisième résonateur acoustique (AWR103) disposé entre un troisième noeud (N105) milieu entre lesdites premières bobines (LBPF101, LBF102) et un quatrième noeud (GND100) ; et
- un quatrième résonateur acoustique (AWR104) disposé entre un cinquième noeud (N106) milieu entre lesdites deuxièmes bobines (LBPF103, LBF104) et ledit quatrième noeud (GND100).

## Description

### Domaine technique

La présente description concerne de façon générale le traitement et la transmission de signaux périodiques comme des signaux radiofréquences. La présente description se rapporte plus particulièrement à la réalisation d'une opération de filtrage d'un signal radiofréquence.

### Technique antérieure

Les signaux périodiques, comme les signaux radiofréquence, sont très fréquemment utilisés pour transmettre des informations. Leur traitement est essentiel pour une bonne transmission de données.

L'utilisation de filtres de différents types fait partie des traitements classiques appliqués aux signaux périodiques.

Il serait souhaitable de pouvoir améliorer, au moins en partie, certains aspects des circuits de filtrage de signaux périodiques.

### Résumé de l'invention

Il existe un besoin pour des circuits de filtrage de signaux périodiques plus performants.

Il existe un besoin pour des circuits de filtrage de signaux radiofréquence plus performants.

Il existe un besoin pour des circuits de filtrage passe-bande de signaux radiofréquence plus performants.

Il existe un besoin pour des circuits de filtrage passe-bande de signaux radiofréquence permettant de filtrer des signaux ayant une fréquence comprise dans une plus large bande de fréquence.

Il existe un besoin pour un procédé de filtrage présentant ces mêmes avantages.

Il existe un besoin pour une chaine de transmission utilisant un tel circuit de filtrage.

Il existe un besoin pour un procédé de transmission de signaux présentant ces mêmes avantages.

Un mode de réalisation pallie tout ou partie des inconvénients des circuits de filtrage connus.

Un mode de réalisation pallie tout ou partie des inconvénients des procédés de filtrage de signaux connus.

Un mode de réalisation pallie tout ou partie des inconvénients des chaines de transmission connues.

Un mode de réalisation pallie tout ou partie des inconvénients des procédés de transmission connus.

Un mode de réalisation prévoit un circuit de filtrage passe-bande comprenant, en série, un premier filtre passe-haut, un filtre passe-bande et un deuxième filtre passe-haut, dans lequel le filtre passe-bande comprend :
- un premier résonateur acoustique et un deuxième résonateur acoustique disposés en série entre un premier noeud et un deuxième noeud ;
- au moins deux premières bobines disposées en série entre elles, et disposées en parallèle avec ledit premier résonateur acoustique ;
- au moins deux deuxièmes bobines disposées en série entre elles, et disposées en parallèle avec ledit deuxième résonateur acoustique ;
- au moins un troisième résonateur acoustique disposé entre un troisième noeud milieu entre lesdites premières bobines et un quatrième noeud de référence ; et
- au moins un quatrième résonateur acoustique disposé entre un cinquième noeud milieu entre lesdites deuxièmes bobines et ledit quatrième noeud de référence.

Un autre mode de réalisation prévoit un procédé de filtrage d'un signal radiofréquence utilisant un circuit de filtrage passe-bande comprenant, en série, un premier filtre passe-haut, un filtre passe-bande et un deuxième filtre passe-haut, dans lequel le filtre passe-bande comprend :
- un premier résonateur acoustique et un deuxième résonateur acoustique disposés en série entre un premier noeud et un deuxième noeud ;
- au moins deux premières bobines disposées en série entre elles, et disposées en parallèle avec ledit premier résonateur acoustique ;
- au moins deux deuxièmes bobines disposées en série entre elles, et disposées en parallèle avec ledit deuxième résonateur acoustique ;
- au moins un troisième résonateur acoustique disposé entre un troisième noeud milieu entre lesdites premières bobines et un quatrième noeud de référence ; et
- au moins un quatrième résonateur acoustique disposé entre un cinquième noeud milieu entre lesdites deuxièmes bobines et ledit quatrième noeud de référence.

Selon un mode de réalisation, les premier et deuxième résonateurs acoustiques sont identiques,
dans lequel les premières bobines sont identiques aux deuxièmes bobines, et
les troisième et quatrième résonateurs acoustiques sont identiques.

Selon un mode de réalisation, le premier résonateur acoustique peut comprendre au moins deux cinquièmes résonateurs acoustiques disposés en série.

Selon un mode de réalisation, le deuxième résonateur acoustique peut comprendre au moins deux sixièmes résonateurs acoustiques disposés en série.

Selon un mode de réalisation, le premier filtre passe-haut comprend :
- deux premiers condensateurs disposés en série entre un sixième noeud et ledit premier noeud ; et
- un deuxième condensateur et une troisième bobine disposés en série entre un septième noeud milieu entre lesdites premiers condensateurs et ledit quatrième noeud de référence.

Selon un mode de réalisation, le deuxième filtre passe-haut comprend :
- deux troisièmes condensateurs disposés en série entre ledit deuxième noeud et un huitième noeud ; et
- un quatrième condensateur et une quatrième bobine disposés en série entre un neuvième noeud milieu entre lesdites deuxième condensateurs et ledit quatrième noeud de référence.

Selon un mode de réalisation, les premier et deuxième filtre passe-haut sont symétriques par rapport audit filtre passe-bande.

Selon un mode de réalisation, ledit circuit de filtrage comprend, en outre, une cinquième bobine disposés en série entre ledit sixième noeud et ledit quatrième noeud de référence.

Selon un mode de réalisation, ledit circuit de filtrage comprend, en outre, une sixième bobine disposés en série entre ledit septième noeud et ledit quatrième noeud de référence.

Un autre mode de réalisation prévoit une chaine de transmission comprenant un circuit de filtrage décrit précédemment.

Un autre mode de réalisation prévoit un procédé de transmission d'un signal utilisant le procédé de filtrage décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un schéma illustrant un premier mode de réalisation d'un circuit de filtrage passe-bande ;
la figure 2 comprend des graphiques illustrant le fonctionnement du mode de réalisation de la figure 1 ;
la figure 3 comprend un graphique illustrant le fonctionnement du mode de réalisation de la figure 1 ;
la figure 4 représente un schéma illustrant un deuxième mode de réalisation d'un circuit de filtrage passe-bande ;
la figure 5 comprend des graphiques illustrant le fonctionnement du mode de réalisation de la figure 4 ;
la figure 6 comprend un graphique illustrant le fonctionnement du mode de réalisation de la figure 4 ; et
la figure 7 représente une vue de dessus d'une mise en oeuvre pratique des modes de réalisation des figures 1 et 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

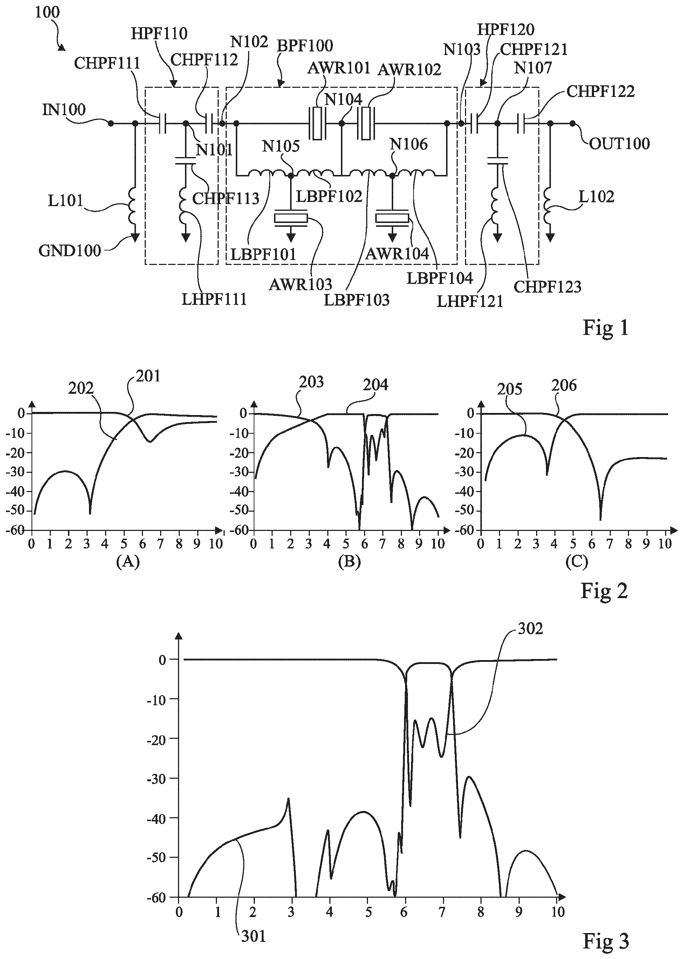

Les modes de réalisation décrits ci-après concernent le filtrage de signaux périodiques, et plus particulièrement le filtrage de signaux radiofréquence, c'est-à-dire des signaux dont les fréquences sont comprises entre 3 kHz et 300 GHz. Les modes de réalisation décrits ci-après sont plus précisément des circuits de filtrage passe-bande dont les caractéristiques d'isolation et de réjection ont été améliorées en vue de leur utilisation dans le domaine des communications utilisant des ensembles de protocoles de communication sans fil, comme les protocoles de communication Wi-Fi. Pour cela, ces circuits de filtrage sont conçus pour laisser passer des signaux ayant des fréquences comprises entre 6 GHz et 7,2 GHz, plus particulièrement comprises entre 6,105 GHz et 7,125 GHz, et pour rejeter des signaux ayant des fréquences de l'ordre de 5 GHz. Ces modes de réalisation sont décrits en détails en relation avec les figures 1 à 7. Ces modes de réalisation sont particulièrement adaptés à être utilisés dans des chaines de transmission d'information et/ou de données.

De plus, les modes de réalisation décrits ci-dessus sont particulièrement adaptés à être utilisés dans tout type de marchés industriels où le filtrage de signaux périodiques est utile. Plus particulièrement, un tel circuit de filtrage passe-bande peut être destiné à :
- l'industrie automobile, par exemple dans le domaine de l'électrification automobile et la télématique automobile ou dans le domaine des systèmes avancés d'aide à la conduite (Advanced Driver Assistance Systems - ADAS) ;
- l'industrie industrielle, par exemple dans le domaine de l'énergie verte, dans le domaine de l'électrification des infrastructures, de l'internet des objets (Internet of Things
- IoT) et des maisons intelligentes (SmartHome), où la consommation d'électricité et d'énergie et l'échange de données sont des éléments clés ;
- l'industrie de l'électronique personnelle, par exemple dans le domaine de la téléphonie mobile et de l'internet des objets (Internet of Things - IoT), ainsi que dans le domaine des interfaces haut débit ; et
- l'industrie des équipements de communication, des ordinateurs et des périphériques, par exemple dans le domaine des infrastructures et des centres de données (Data Centers), et dans le domaine des satellites en orbite terrestre basse (Low Earth Orbit - LEO).

La figure 1 représente un schéma électrique d'un premier mode de réalisation d'un circuit de filtrage passe-bande 100.

Le circuit 100 comprend un noeud d'entrée IN100 et un noeud de sortie OUT100. Le noeud d'entrée IN100 est adapté à recevoir des signaux périodiques destinés à être filtrés. Le noeud de sortie OUT100 est adapté à fournir des signaux périodiques filtrés. Le circuit 100 est, en outre, référencé à un noeud de référence GND100 recevant un potentiel de référence, par exemple la masse.

Le circuit 100 comprend, en outre et de façon optionnelle, une première bobine L101 de protection contre les décharges électrostatiques. Une première borne de la bobine L101 est reliée, de préférence connectée, au noeud d'entrée IN100, et une deuxième borne de la bobine L101 est reliée, de préférence connectée, au noeud de référence GND100.

Le circuit 100 comprend, en outre et de façon optionnelle, une deuxième bobine L102 de protection contre les décharges électrostatiques. Une première borne de la bobine L102 est reliée, de préférence connectée, au noeud de sortie OUT100, et une deuxième borne de la bobine L102 est reliée, de préférence connectée, au noeud de référence GND100.

Selon un mode de réalisation, le circuit 100 comprend, en outre, un premier filtre passe-haut HPF110 comprenant un noeud d'entrée relié, de préférence connecté, au noeud d'entrée IN100, et un noeud de sortie N102. Selon un exemple, le filtre HPF110 comprend trois condensateurs CHPF111, CHPF112 et CHPF113, et une bobine LHPF111.

Selon un exemple, les condensateurs CHPF111 et CHPF112 sont disposés en série entre les noeuds IN100 et N102. Plus particulièrement, une première borne du condensateur CHPF111 est reliée, de préférence connectée, au noeud IN100, et une deuxième borne du condensateur CHPF111 est reliée, de préférence connectée, à un noeud N101. Une première borne du condensateur CHPF112 est reliée, de préférence connectée, au noeud N101, et une deuxième borne du condensateur CHPF111 est reliée, de préférence connectée, au noeud N102.

Selon un exemple, le condensateur CHPF113 et la bobine LHPF111 sont disposés en série entre les noeuds N101 et GND100. Plus particulièrement, une première borne du condensateur CHPF113 est reliée, de préférence connectée, au noeud N101, et une deuxième borne du condensateur CHPF113 est reliée, de préférence connectée, à une première borne de la bobine LHPF111. Une deuxième borne de la bobine LHPF111 est reliée, de préférence connectée, au noeud GND100.

Le filtre HPF110 décrit ici est un filtre passe-haut de 1^{er} ordre. Selon une variante de réalisation, le filtre HPF110 pourrait être un filtre passe-haut d'ordre supérieur.

Selon un mode de réalisation, le circuit comprend, en outre, un filtre passe-bande BPF100 comprenant un noeud d'entrée relié, de préférence connecté, au noeud N102 de sortie du filtre passe-haut HPF110, et un noeud de sortie N103. Selon un exemple, le filtre BPF110 comprend quatre résonateurs acoustiques AWR101, AWR102, AWR103 et AWR104, et quatre bobines LBPF101, LBPF102, LBPF103 et LBPF104. On appelle ici résonateur acoustique un composant mécanique et électronique utilisant, par exemple, un matériau piézoélectrique qui entre en résonnance entre deux plaques conductrices, comme des plaques métalliques.

Selon un mode de réalisation, les résonateurs AWR101 et AWR102 sont disposés en série entre les noeuds N102 et N103. Plus particulièrement, une première borne du résonateur AWR101 est reliée, de préférence connectée, au noeud N102, et une deuxième borne du résonateur AWR101 est reliée, de préférence connectée, à un noeud N104. Une première borne du résonateur AWR102 est reliée, de préférence connectée, au noeud N104, et une deuxième borne du résonateur AWR102 est reliée, de préférence connectée, au noeud N103.

Selon une variante de réalisation, chaque résonateur AWR101, AWR102 peut être remplacé par un montage série d'au moins deux résonateurs acoustiques. Cela peut avoir pour avantage l'augmentation de la surface des résonateurs acoustiques tout en conservant la valeur de la capacité totale du circuit pour faciliter la fabrication et avoir d'une meilleure tenue en puissance.

Selon un mode de réalisation, les bobines LBPF101 et LBPF102 sont disposées en série entre les noeuds N102 et N104. Autrement dit, les bobines LBPF101 et LBPF102 sont disposées en série entre elles, et en parallèle avec le résonateur acoustique AWR101. Plus particulièrement, une première borne de la bobine LBPF101 est reliée, de préférence connectée, au noeud N102, et une deuxième borne de la bobine LBPF101 est reliée, de préférence connectée, à un noeud N105. Une première borne de la bobine LBPF102 est reliée, de préférence connectée, au noeud N105, et une deuxième borne de la bobine LBPF102 est reliée, de préférence connectée, au noeud N104.

Selon un mode de réalisation, les bobines LBPF103 et LBPF104 sont disposées en série entre les noeuds N104 et N103. Autrement dit, les bobines LBPF103 et LBPF104 sont disposées en série entre elles, et en parallèle avec le résonateur acoustique AWR102. Plus particulièrement, une première borne de la bobine LBPF103 est reliée, de préférence connectée, au noeud N104, et une deuxième borne de la bobine LBPF103 est reliée, de préférence connectée, à un noeud N106. Une première borne de la bobine LBPF104 est reliée, de préférence connectée, au noeud N106, et une deuxième borne de la bobine LBPF104 est reliée, de préférence connectée, au noeud N103.

Selon un mode de réalisation, le résonateur AWR103 relie le noeud N105 au noeud de référence GND100. Autrement dit, une première borne du résonateur AWR103 est reliée, de préférence connectée, au noeud N105, et une deuxième borne du résonateur AWR103 est reliée, de préférence connectée, au noeud GND100.

Selon un mode de réalisation, le résonateur AWR104 relie le noeud N106 au noeud de référence GND100. Autrement dit, une première borne du résonateur AWR104 est reliée, de préférence connectée, au noeud N106, et une deuxième borne du résonateur AWR104 est reliée, de préférence connectée, au noeud GND100.

Selon une variante de réalisation, chaque résonateur AWR103, AWR104 peut être remplacé par un montage série d'au moins deux résonateurs acoustiques. Cela peut avoir pour avantage l'augmentation de la surface des résonateurs acoustiques tout en conservant la valeur de la capacité totale du circuit pour faciliter la fabrication et avoir d'une meilleure tenue en puissance.

Selon un mode de réalisation, le circuit comprend, en outre, un deuxième filtre passe-haut HPF120 comprenant un noeud d'entrée relié, de préférence connecté, au noeud N103 de sortie du filtre passe-bande BPF100, et un noeud de sortie relié, de préférence connecté, au noeud de sortie OUT100. Selon un exemple, le filtre HPF120 comprend trois condensateurs CHPF121, CHPF122 et CHPF123, et une bobine LHPF121.

Selon un exemple, les condensateurs CHPF121 et CHPF122 sont disposés en série entre les noeuds N103 et OUT100. Plus particulièrement, une première borne du condensateur CHPF121 est reliée, de préférence connectée, au noeud N103, et une deuxième borne du condensateur CHPF121 est reliée, de préférence connectée, à un noeud N107. Une première borne du condensateur CHPF122 est reliée, de préférence connectée, au noeud N107, et une deuxième borne du condensateur CHPF122 est reliée, de préférence connectée, au noeud OUT100.

Selon un exemple, le condensateur CHPF123 et la bobine LHPF121 sont disposés en série entre les noeuds N107 et GND100. Plus particulièrement, une première borne du condensateur CHPF123 est reliée, de préférence connectée, au noeud N107, et une deuxième borne du condensateur CHPF123 est reliée, de préférence connectée, à une première borne de la bobine LHPF121. Une deuxième borne de la bobine LHPF121 est reliée, de préférence connectée, au noeud GND100.

Le filtre HPF120 décrit ici est un filtre passe-haut de 1^{er} ordre. Selon une variante de réalisation, le filtre HPF120 pourrait être un filtre passe-haut d'ordre supérieur.

Selon un exemple pratique de l'invention, les composants du circuit de filtrage 100 peuvent présenter les valeurs numériques suivantes. Il est à noter que d'autres valeurs peuvent être imaginées et leur détermination est à la portée de la personne du métier.

Dans le filtre passe-haut HPF110 :
- le condensateur CHPF111 a une capacité comprise entre 0,1 et 5 pF, par exemple de l'ordre de 0,53 pF ;
- le condensateur CHPF112 a une capacité comprise entre 0,1 et 5 pF, par exemple de l'ordre de 0,61 pF ;
- le condensateur CHPF113 a une capacité comprise entre 0,1 et 5 pF, par exemple de l'ordre de 1,53 pF ; et
- la bobine LHPF111 a une inductance comprise entre 0.1 et 5 nH, par exemple de l'ordre de 1,51 nH.

Dans le filtre passe-bande BPF100 :
- la bobine LHPF101 a une inductance comprise entre 0.1 et 5 nH, par exemple de l'ordre de 1,61 nH ;
- la bobine LHPF102 a une inductance comprise entre 0.1 et 5 nH, par exemple de l'ordre de 1 nH ;
- la bobine LHPF103 a une inductance comprise entre 0.1 et 5 nH, par exemple de l'ordre de 1,4 nH ;
- la bobine LHPF104 a une inductance comprise entre 0.1 et 5 nH, par exemple de l'ordre de 0,93 nH ;
- le résonateur acoustique AWR101 a une capacité comprise entre 0,1 et 5 pF, par exemple de l'ordre de 0,524 pF, a une fréquence de résonance comprise entre 5 et 10 GHz, par exemple de l'ordre de 6,51 GHz, et a une fréquence d'antirésonance comprise entre 5 et 10 GHz, par exemple de l'ordre de 7,02 GHz ;
- le résonateur acoustique AWR102 a une capacité comprise entre 0,1 et 5 pF, par exemple de l'ordre de 0,314 pF, a une fréquence de résonance comprise entre 5 et 10 GHz, par exemple de l'ordre de 6,46 GHz, et a une fréquence d'antirésonance comprise entre 5 et 10 GHz, par exemple de l'ordre de 6,98 GHz ;
- le résonateur acoustique AWR103 a une capacité comprise entre 0,1 et 5 pF, par exemple de l'ordre de 0,206 pF, a une fréquence de résonance comprise entre 5 et 10 GHz, par exemple de l'ordre de 6,09 GHz, et a une fréquence d'antirésonance comprise entre 5 et 10 GHz, par exemple de l'ordre de 6,57 GHz ; et
- le résonateur acoustique AWR104 a une capacité comprise entre 0,1 et 5 pF, par exemple de l'ordre de 0,200 pF, a une fréquence de résonance comprise entre 5 et 10 GHz, par exemple de l'ordre de 6,10 GHz, et a une fréquence d'antirésonance comprise entre 5 et 10 GHz, par exemple de l'ordre de 6,57 GHz.

Dans le filtre passe-haut HPF120 :
- le condensateur CHPF121 a une capacité comprise entre 0,1 et 5 pF, par exemple de l'ordre de 1,86 pF ;
- le condensateur CHPF122 a une capacité comprise entre 0,1 et 5 pF, par exemple de l'ordre de 1,75 pF ;
- le condensateur CHPF123 a une capacité comprise entre 0,1 et 5 pF, par exemple de l'ordre de 1 pF ; et
- la bobine LHPF121 a une inductance comprise entre 0.1 et 5 nH, par exemple de l'ordre de 1,76 nH.

Le fonctionnement du circuit de filtrage passe-bande 100 est décrit en détail en relation avec les figures 2 et 3.

Un procédé de filtrage d'un signal périodique, comme un signal radiofréquence, utilisant un circuit de filtrage du type du circuit de filtrage 100 décrit ici est également couvert par cette description.

De plus, le circuit de filtrage passe-bande 100 peut être utilisé au sein d'une chaine de transmission d'information et/ou de données. Un procédé de transmission d'information et/ou de données utilisant une telle chaine de transmission est couvert par cette description.

La figure 2 comprend trois graphiques (A), (B) et (C) illustrant le fonctionnement des trois filtres compris dans le circuit de filtrage 100 décrit en relation avec la figure 1.

Plus particulièrement, le graphique (A) illustre le fonctionnement du filtre passe-haut HPF110. Le graphique (B) illustre le fonctionnement du filtre passe-bande BPF100. Le graphique (C) illustre le fonctionnement du filtre passe-haut HPF120.

Chacun des graphiques (A), (B) et (C) comprend deux courbes illustrant les performances en termes d'adaptation et d'atténuation du filtre en fonction de la fréquence du signal reçu par le filtre. Plus particulièrement, une première courbe représente l'adaptation du filtre, c'est-à-dire le rapport de la puissance réfléchie et de la puissance incidente en décibels, aussi appelé Return Loss en anglais. Une deuxième courbe représente quant à elle l'atténuation du filtre, c'est-à-dire la diminution relative de la puissance d'un signal en cours de transmission qui peut s'exprimer par le ratio entre la puissance du signal d'entrée et celle du signal de sortie (ratio mesuré en décibels).

En particulier, le graphique (A) comprend une courbe 201 illustrant l'adaptation du filtre passe-haut HPF110, et une courbe 202 illustrant l'atténuation du filtre passe-haut HPF110. Pour réaliser cette simulation, sont considérés un signal d'entrée appliqué au niveau du noeud IN100 et un signal de sortie fourni par le noeud N102. Les courbes 201 et 202 montrent que le filtre HPF110 rejette tout signal ayant une fréquence inférieure à 5 GHz, et présente une faible perte d'insertion pour les signaux ayant une fréquence supérieure à 5 GHz.

Le graphique (B) comprend une courbe 203 illustrant l'atténuation du filtre passe-bande BPF100, et une courbe 204 illustrant l'adaptation du filtre passe-bande BPF100. Pour réaliser cette simulation, sont considérés un signal d'entrée appliqué au niveau du noeud N102 et un signal de sortie fourni par le noeud N103. Les courbes 203 et 204 montrent que le filtre BPF100 laisse passer tout signal ayant une fréquence comprise entre environ 6 GHz et 7,5 GHz, et présente une atténuation pour les signaux ayant une fréquence comprise entre environ 3 GHz et 6GHz et supérieure à 7 GHz.

Le graphique (C) comprend une courbe 205 illustrant l'atténuation du filtre passe-haut HPF120, et une courbe 206 illustrant l'adaptation du filtre passe-haut HPF120. Pour réaliser cette simulation, sont considérés un signal d'entrée appliqué au niveau du noeud N103 et un signal de sortie fourni par le noeud OUT100. Les courbes 205 et 206 montrent que le filtre HPF120 rejette tout signal ayant une fréquence inférieure à environ 4 GHz, et présente une faible perte d'insertion pour les signaux ayant une fréquence supérieure à 4 GHz.

La figure 3 est un graphique illustrant le fonctionnement du circuit 100 décrit en relation avec la figure 1.

Plus particulièrement, le graphique de la figure 3 illustre le fonctionnement du circuit de filtrage 100, c'est-à-dire l'association des filtres HPF110, BPF100 et HPF120 dont le fonctionnement a été décrit précédemment.

Ainsi, comme les graphiques (A), (B) et (C), le graphique de la figure 3 comprend deux courbes illustrant les performances en termes d'adaptation et d'atténuation du circuit de filtrage en fonction de la fréquence du signal reçu par le filtre. Plus particulièrement, une première courbe représente l'adaptation du filtre, c'est-à-dire le rapport de la puissance réfléchie et de la puissance incidente en décibels, aussi appelé Return Loss en anglais. Une deuxième courbe représente quant à elle l'atténuation du filtre, c'est-à-dire la diminution relative de la puissance d'un signal en cours de transmission qui peut s'exprimer par le ratio entre la puissance du signal d'entrée et celle du signal de sortie (ratio mesuré en décibels).

Ainsi, le graphique de la figure 3 comprend une courbe 301 illustrant l'atténuation du circuit de filtrage passe-bande 100, et une courbe 302 illustrant l'adaptation du circuit de filtrage passe-bande 100. Pour réaliser cette simulation, sont considérés un signal d'entrée appliqué au niveau du noeud IN100 et un signal de sortie fourni par le noeud OUT100. Les courbes 301 et 302 montrent que le circuit de filtrage 100 rejette tout signal ayant une fréquence inférieure 6 GHz et supérieure à environ 7,2 GHz.

Un avantage du circuit de filtrage 100 de la figure 1 est qu'il permet de réaliser d'obtenir une atténuation ou une rejection inférieure à -40 dB, de l'ordre de -49 dB, pour un signal ayant une fréquence de l'ordre de 5.895 GHz.

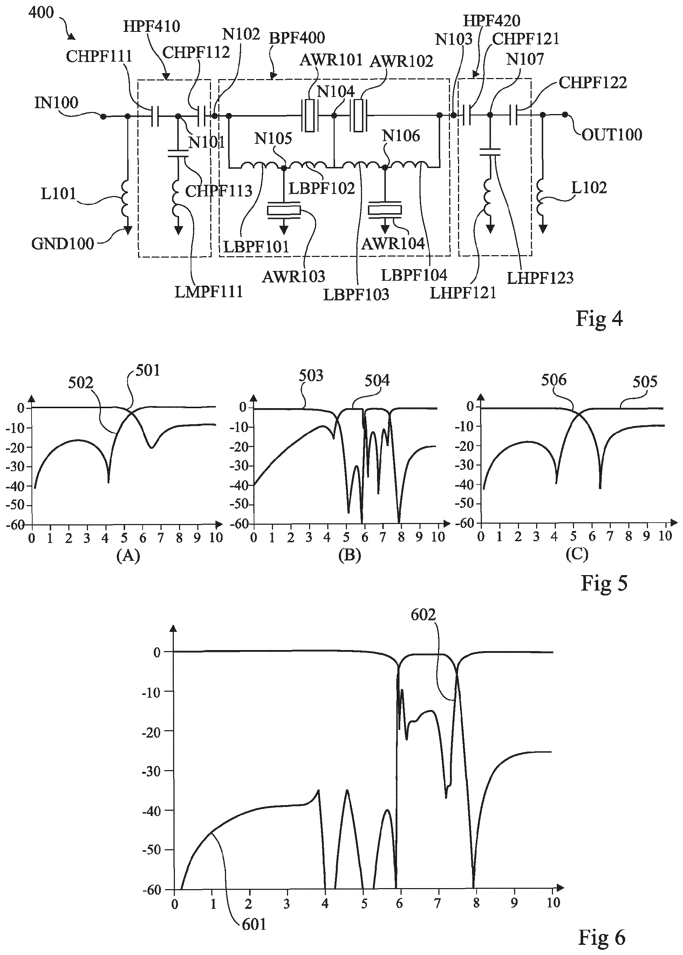

La figure 4 représente un schéma électrique d'un premier mode de réalisation d'un circuit de filtrage passe-bande 400.

Le circuit de filtrage passe-bande 400 est similaire au circuit de filtrage passe-bande 100 décrit en relation avec la figure 1. Les éléments communs aux circuits 100 et 400 ne sont pas décrits de nouveau en détail ici. Seules les différences entre les circuits 100 et 400 sont mises en exergue.

Le circuit de filtrage passe-bande 400 comprend les mêmes composants que le circuit de filtrage passe-bande 100, mais présente, en outre, une symétrie des caractéristiques de ces composants. Plus particulièrement, le noeud N104 forme un axe de symétrie du circuit 400.

En particulier, sont identiques deux à deux les composants suivants :
- le condensateur CHPF111 du filtre HPF110 et le condensateur CHPF122 du filtre HPF120 ;
- le condensateur CHPF112 du filtre HPF110 et le condensateur CHPF121 du filtre HPF120 ;
- le condensateur CHPF113 du filtre HPF110 et le condensateur CHPF123 du filtre HPF120 ;
- la bobine LHPF111 du filtre HPF110 et la bobine LHPF121 du filtre HPF120 ;
- les résonateurs AWR101 et AWR102 du filtre BPF100 ;
- les bobines LBPF101 et LBPF104 du filtre BPF100 ;
- les bobines LBPF102 et LBPF103 du filtre BPF100 ; et
- les résonateurs AWR103 et AWR104 du filtre BPF100.

Selon un exemple pratique de l'invention, les composants du circuit de filtrage 400 peuvent présenter les valeurs numériques suivantes. Il est à noter que d'autres valeurs peuvent être imaginées et leur détermination est à la portée de la personne du métier.

Dans le filtre passe-haut HPF410 :
- le condensateur CHPF111 a une capacité comprise entre 0,1 et 5 pF, par exemple de l'ordre de 0,86 pF ;
- le condensateur CHPF112 a une capacité comprise entre 0,1 et 5 pF, par exemple de l'ordre de 0,93 pF ;
- le condensateur CHPF113 a une capacité comprise entre 0,1 et 5 pF, par exemple de l'ordre de 0,84 pF ; et
- la bobine LHPF111 a une inductance comprise entre 0.1 et 5 nH, par exemple de l'ordre de 1,57 nH.

Dans le filtre passe-bande BPF400 :
- la bobine LHPF101 a une inductance comprise entre 0.1 et 5 nH, par exemple de l'ordre de 0,74 nH ;
- la bobine LHPF102 a une inductance comprise entre 0.1 et 5 nH, par exemple de l'ordre de 0,74 nH ;
- la bobine LHPF103 a une inductance comprise entre 0.1 et 5 nH, par exemple de l'ordre de 0,51 nH ;
- la bobine LHPF104 a une inductance comprise entre 0.1 et 5 nH, par exemple de l'ordre de 0,51 nH ;
- le résonateur acoustique AWR101 a une capacité comprise entre 0,1 et 5 pF, par exemple de l'ordre de 0,587 pF, a une fréquence de résonance comprise entre 5 et 10 GHz, par exemple de l'ordre de 6,51 GHz, et a une fréquence d'antirésonance comprise entre 5 et 10 GHz, par exemple de l'ordre de 7,03 GHz ;
- le résonateur acoustique AWR102 a une capacité comprise entre 0,1 et 5 pF, par exemple de l'ordre de 0,587 pF, a une fréquence de résonance comprise entre 5 et 10 GHz, par exemple de l'ordre de 6,51 GHz, et a une fréquence d'antirésonance comprise entre 5 et 10 GHz, par exemple de l'ordre de 7,03 GHz ;
- le résonateur acoustique AWR103 a une capacité comprise entre 0,1 et 5 pF, par exemple de l'ordre de 0,264 pF, a une fréquence de résonance comprise entre 5 et 10 GHz, par exemple de l'ordre de 6,01 GHz, et a une fréquence d'antirésonance comprise entre 5 et 10 GHz, par exemple de l'ordre de 6,51 GHz ;
- le résonateur acoustique AWR104 a une capacité comprise entre 0,1 et 5 pF, par exemple de l'ordre de 0,264 pF, a une fréquence de résonance comprise entre 5 et 10 GHz, par exemple de l'ordre de 6,01 GHz, et a une fréquence d'antirésonance comprise entre 5 et 10 GHz, par exemple de l'ordre de 6,51 GHz ;

Dans le filtre passe-haut HPF420 :
- le condensateur CHPF121 a une capacité comprise entre 0,1 et 5 pF, par exemple de l'ordre de 0,86 pF ;
- le condensateur CHPF122 a une capacité comprise entre 0,1 et 5 pF, par exemple de l'ordre de 0,93 pF ;
- le condensateur CHPF123 a une capacité comprise entre 0,1 et 5 pF, par exemple de l'ordre de 0,84 pF ; et
- la bobine LHPF121 a une inductance comprise entre 0.1 et 5 nH, par exemple de l'ordre de 1,57 nH.

La figure 5 comprend trois graphiques (A), (B) et (C) illustrant le fonctionnement des trois filtres compris dans le circuit de filtrage 400 décrit en relation avec la figure 4.

Plus particulièrement, le graphique (A) illustre le fonctionnement du filtre passe-haut HPF410. Le graphique (B) illustre le fonctionnement du filtre passe-bande BPF400. Le graphique (C) illustre le fonctionnement du filtre passe-haut HPF420.

Comme décrit en relation avec la figure 2, chacun des graphiques (A), (B) et (C) de la figure 4 comprend deux courbes illustrant les performances en termes d'adaptation et d'atténuation du filtre en fonction de la fréquence du signal reçu par le filtre. Plus particulièrement, une première courbe représente l'adaptation du filtre, c'est-à-dire le rapport de la puissance réfléchie et de la puissance incidente en décibels, aussi appelé Return Loss en anglais. Une deuxième courbe représente quant à elle l'atténuation du filtre, c'est-à-dire la diminution relative de la puissance d'un signal en cours de transmission qui peut s'exprimer par le ratio entre la puissance du signal d'entrée et celle du signal de sortie (ratio mesuré en décibels).

En particulier, le graphique (A) comprend une courbe 501 illustrant l'adaptation du filtre passe-haut HPF410, et une courbe 502 illustrant l'atténuation du filtre passe-haut HPF410. Pour réaliser cette simulation, sont considérés un signal d'entrée appliqué au niveau du noeud IN100 et un signal de sortie fourni par le noeud N102. Les courbes 501 et 502 montrent que le filtre HPF410 rejette tout signal ayant une fréquence inférieure à 5 GHz, et présente une faible perte d'insertion pour les signaux ayant une fréquence supérieure à 5 GHz.

Le graphique (B) comprend une courbe 503 illustrant l'atténuation du filtre passe-bande BPF400, et une courbe 504 illustrant l'adaptation du filtre passe-bande BPF400. Pour réaliser cette simulation, sont considérés un signal d'entrée appliqué au niveau du noeud N102 et un signal de sortie fourni par le noeud N103. Les courbes 503 et 504 montrent que le filtre HPF400 laisse passer tout signal ayant une fréquence inférieure à 4,5 GHz, et comprise entre environ 6 GHz et 7,5 GHz, et présente une atténuation ou réjection pour les signaux ayant une fréquence comprise entre environ 4,5 GHz et 6 GHz et supérieure à 8 GHz.

Le graphique (C) comprend une courbe 505 illustrant l'atténuation du filtre passe-haut HPF420, et une courbe 506 illustrant l'adaptation du filtre passe-haut HPF420. Pour réaliser cette simulation, sont considérés un signal d'entrée appliqué au niveau du noeud N103 et un signal de sortie fourni par le noeud OUT100. Les courbes 505 et 506 montrent que le filtre HPF420 rejette tout signal ayant une fréquence inférieure à environ 5 GHz, et présente une faible perte d'insertion pour les signaux ayant une fréquence supérieure à 5 GHz.

La figure 6 est un graphique illustrant le fonctionnement du circuit 400 décrit en relation avec la figure 4.

Plus particulièrement, le graphique de la figure 6 illustre le fonctionnement du circuit de filtrage 400, c'est-à-dire l'association des filtres HPF410, BPF400 et HPF420 dont le fonctionnement a été décrit précédemment.

Ainsi, comme les graphiques (A), (B) et (C), le graphique de la figure 5 comprend deux courbes illustrant les performances en termes d'adaptation et d'atténuation du circuit de filtrage en fonction de la fréquence du signal reçu par le filtre. Plus particulièrement, une première courbe représente l'adaptation du filtre, c'est-à-dire le rapport de la puissance réfléchie et de la puissance incidente en décibels, aussi appelé Return Loss en anglais. Une deuxième courbe représente quant à elle l'atténuation du filtre, c'est-à-dire la diminution relative de la puissance d'un signal en cours de transmission qui peut s'exprimer par le ratio entre la puissance du signal d'entrée et celle du signal de sortie (ratio mesuré en décibels).

Ainsi, le graphique de la figure 6 comprend une courbe 601 illustrant l'atténuation du circuit de filtrage passe-bande 400, et une courbe 602 illustrant l'adaptation du circuit de filtrage passe-bande 400. Pour réaliser cette simulation, sont considérés un signal d'entrée appliqué au niveau du noeud IN100 et un signal de sortie fourni par le noeud OUT100. Les courbes 601 et 602 montrent que le circuit de filtrage 400 rejette tout signal ayant une fréquence inférieure 6 GHz et supérieure à environ 8 GHz.

Un avantage du circuit de filtrage 100 de la figure 1 est qu'il permet de réaliser d'obtenir un gain de rejet inférieur à -40 dB, de l'ordre de -38 dB, pour une fréquence de l'ordre de 5,895 GHz.

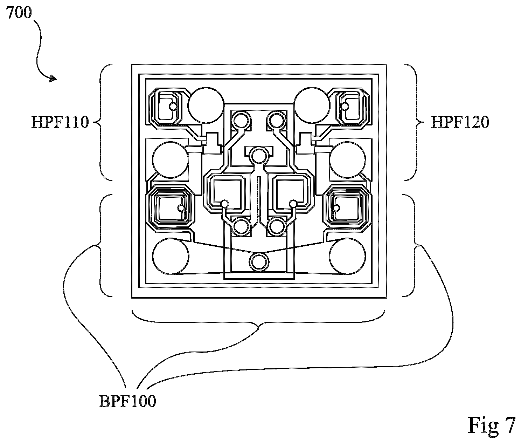

La figure 7 est une vue de dessus illustrant une mise en oeuvre pratique d'un circuit 700 du type des circuits de filtrage passe-bande 100 et 400 décrits en relation avec les figures 1 et 4.

La figure 7 montre la position des différents composants des circuits de filtrage passe-bande 100 et 400, et plus particulièrement le positionnement du filtre passe-haut HPF110, du filtre passe-bande BPF100 et du filtre passe-haut HPF120.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Circuit de filtrage passe-bande (100 ; 400) comprenant, en série, un premier filtre passe-haut (HPF110 ; HPF410), un filtre passe-bande (BPF100 ; BPF400) et un deuxième filtre passe-haut (HPF120 ; HPF420), dans lequel le filtre passe-bande (BPF100 ; BPF400) comprend :
- un premier résonateur acoustique (AWR101) et un deuxième résonateur acoustique (AWR102) disposés en série entre un premier noeud (N102) et un deuxième noeud (N103) ;
- au moins deux premières bobines (LBPF101, LBF102) disposées en série entre elles, et disposées en parallèle avec ledit premier résonateur acoustique (AWR101) ;
- au moins deux deuxièmes bobines (LBPF103, LBF104) disposées en série entre elles, et disposées en parallèle avec ledit deuxième résonateur acoustique (AWR102) ;
- au moins un troisième résonateur acoustique (AWR103) disposé entre un troisième noeud (N105) milieu entre lesdites premières bobines (LBPF101, LBF102) et un quatrième noeud de référence (GND100) ; et
- au moins un quatrième résonateur acoustique (AWR104) disposé entre un cinquième noeud (N106) milieu entre lesdites deuxièmes bobines (LBPF103, LBF104) et ledit quatrième noeud de référence (GND100).

2. Procédé de filtrage d'un signal radiofréquence utilisant un circuit de filtrage passe-bande (100 ; 400) comprenant, en série, un premier filtre passe-haut (HPF110 ; HPF410), un filtre passe-bande (BPF100 ; BPF400) et un deuxième filtre passe-haut (HPF120 ; HPF420), dans lequel le filtre passe-bande (BPF100 ; BPF400) comprend :
- un premier résonateur acoustique (AWR101) et un deuxième résonateur acoustique (AWR102) disposés en série entre un premier noeud (N102) et un deuxième noeud (N103) ;
- au moins deux premières bobines (LBPF101, LBF102) disposées en série entre elles, et disposées en parallèle avec ledit premier résonateur acoustique (AWR101) ;
- au moins deux deuxièmes bobines (LBPF103, LBF104) disposées en série entre elles, et disposées en parallèle avec ledit deuxième résonateur acoustique (AWR102) ;
- au moins un troisième résonateur acoustique (AWR103) disposé entre un troisième noeud (N105) milieu entre lesdites premières bobines (LBPF101, LBF102) et un quatrième noeud de référence (GND100) ; et
- au moins un quatrième résonateur acoustique (AWR104) disposé entre un cinquième noeud (N106) milieu entre lesdites deuxièmes bobines (LBPF103, LBF104) et ledit quatrième noeud de référence (GND100).

3. Circuit selon la revendication 1, ou procédé selon la revendication 2, dans lequel les premier et deuxième résonateurs acoustiques (AWR101, AWR102) sont identiques, dans lequel les premières bobines (LBPF101, LBF102) sont identiques aux deuxièmes bobines (LBPF103, LBF104), et les troisième et quatrième résonateurs acoustiques (AWR103, AWR104) sont identiques.

4. Circuit selon la revendication 1 ou 3, ou procédé selon la revendication 2 ou 3, dans lequel le premier résonateur acoustique (AWR101) peut comprendre au moins deux cinquièmes résonateurs acoustiques disposés en série.

5. Circuit selon l'une quelconque des revendications 1, 3 ou 4, ou procédé selon l'une quelconque des revendications 2 à 4, dans lequel le deuxième résonateur acoustique (AWR102) peut comprendre au moins deux sixièmes résonateurs acoustiques disposés en série.

6. Circuit selon l'une quelconque des revendications 1, 3 à 5, ou procédé selon l'une quelconque des revendications 2 à 5, dans lequel le premier filtre passe-haut (HPF110 ; HPF410) comprend :
- deux premiers condensateurs (CHPF111, CHPF112) disposés en série entre un sixième noeud (IN100) et ledit premier noeud (N102) ; et
- un deuxième condensateur (CHPF113) et une troisième bobine (LHPF111) disposés en série entre un septième noeud (N101) milieu entre lesdites premiers condensateurs (CHPF111, CHPF112) et ledit quatrième noeud de référence (GND100).

7. Circuit selon l'une quelconque des revendications 1, 3 à 6, ou procédé selon l'une quelconque des revendications 2 à 6, dans lequel le deuxième filtre passe-haut (HPF120 ; HPF420) comprend :
- deux troisièmes condensateurs (CHPF121, CHPF122) disposés en série entre ledit deuxième noeud (N102) et un huitième noeud (OUT100) ; et
- un quatrième condensateur (CHPF123) et une quatrième bobine (LHPF121) disposés en série entre un neuvième noeud (N107) milieu entre lesdites deuxième condensateurs (CHPF121, CHPF122) et ledit quatrième noeud de référence (GND100).

8. Circuit selon l'une quelconque des revendications 1, 3 à 7, ou procédé selon l'une quelconque des revendications 2 à 7, dans lequel, les premier et deuxième filtre passe-haut (HPF110 ; HPF410) sont symétriques par rapport audit filtre passe-bande (BPF100 ; BPF400).

9. Circuit selon l'une quelconque des revendications 1, 3 à 8, ou procédé selon l'une quelconque des revendications 2 à 8, dans lequel ledit circuit de filtrage comprend, en outre, une cinquième bobine disposés en série entre ledit sixième noeud (IN100) et ledit quatrième noeud de référence (GND100).

10. Circuit selon l'une quelconque des revendications 1, 3 à 9, ou procédé selon l'une quelconque des revendications 2 à 9, dans lequel ledit circuit de filtrage comprend, en outre, une sixième bobine disposés en série entre ledit septième noeud (OUT100) et ledit quatrième noeud de référence (GND100).

11. Chaine de transmission comprenant un circuit de filtrage selon l'une quelconque des revendications 1, 3 à 10.

12. Procédé de transmission d'un signal utilisant le procédé de filtrage selon l'une quelconque des revendications 2 à 10.
